# EUROPEAN PATENT SPECIFICATION

(11) **EP 0 622 717 B1**
(45) Date of publication and mention of the grant of the patent: **30.12.1998**
(21) Application number: 93830189.2
(22) Date of filing: 30.04.1993
(51) Int. Cl.: G05F 1/00, H03K 17/08, H03K 17/16

(54) **Temperature stable circuit for recycling discharge current during the driving of an inductive load**
Temperaturstabilisierte Entladestromrückleitungsschaltung zum Treiben einer induktiven Last
Circuit à récirculation de courant de décharge de charge inductive avec compensation en température

(43) Date of publication of application: 02.11.1994
(73) Proprietor: STMicroelectronics S.r.l., 20041 Agrate Brianza (Milano) (IT)
(72) Inventor: Rossi, Giorgio, I-20014 Nerviano (MI) (IT); Cocetta, Franco, I-20010 Cornared (MI) (IT); Marchio, Fabio, I-20018 Sedriano (MI) (IT)

(56) References cited:
- EP-A- 0 159 233
- EP-A- 0 399 754
- FR-A- 2 593 946
- US-A- 4 287 436
- US-A- 4 860 152

## Description

This invention relates to an electronic temperature stable circuit which is useful for current recycling while inductive loads are being driven, and particularly to such a circuit which is integrated monolithically.

Within the scope of this invention, the problems connected with inductive loads as used in motor vehicle fuel injection control devices will be considered by way of example.

In such devices, the driving of the current flow through an inductive load representing the injector allows to open and close the device.

In such a case, as the inductive load is being driven, it matters that the control current flowing through the load can be cut off within the shortest possible time, in order for the injector closing time to be made short and the amount of fuel injected accurately metered out.

It is recognized that, in general, the driving of inductive loads brings about some problems during the transients.

In fact, upon cutting off the current flowing through an inductor, a voltage surge (positive or negative overvoltage) occurs at the inductor.

That overvoltage is due to the induced electromotive force tending to clamp the current to the value attained during the "on" period, i.e. during the charging phase.

In the instance of fuel injection control in a motor car, as herein considered, the load has a terminal at a fixed supply potential, so that the potential increase will occur at the linking node to the driver circuit.

Accordingly, the amplitude of the voltage peaks at said node must be limited, since otherwise they may cause breakage of the junctions in the semiconductor elements provided within the driver or other circuits connected to that same inductive load.

In addition, with monolithically integrated circuits, such peaks may be a triggering cause of parasitic transistors.

A state-of-art approach provides for the introduction, between the driver circuit and the inductive load, of circuitry including power elements for the so-called recycling of discharge current from the load.

In that way, the energy stored within the inductive load can be dissipated: the voltage thereat, after attaining a predetermined maximum, will remain constant for a time and then drop back to zero along with the current, following full discharge through the power elements themselves.

The discharge time is dependent on the maximum voltage value attained at the inductor.

In such prior approaches, therefore, the recycle circuit is also to limit the voltage rise to a predetermined top value. This voltage limiting effect is referred to as clamping in technical literature.

Where the current quenching time through the inductive load requires to be accurately controlled, this is accomplished using a recycle circuit so dimensioned as to allow a suitable maximum voltage value to be selected, since, as mentioned, the duration of the discharge phase depends directly on the maximum voltage attained at the inductor upon turning off the driver circuit.

It is of special interest that the adjustment can be performed irrespective of outside conditions, in particular independently of temperature.

A standard approach has been heretofore to use, as the recycling power element, the same power transistor -- whether of the field-effect (usually MOS) type or the bipolar type -- as is used for driving the load.

Auxiliary control circuit arrangements control the voltage value at the load and automatically turn on the power element upon that voltage attaining its predetermined maximum value.

Two main solutions are provided circuit-wise in the prior art.

A first one consists of connecting one or more Zener diodes between the control terminal of the driver power transistor and the inductive load.

That is, the Zener diodes are arranged to set a top voltage value VD at the inductive load, because as that set value --which is equal to the combined Zener voltages -- is exceeded, the diodes will begin to conduct, thereby enabling conduction through the transistor until the inductor is discharged.

A disadvantage of this prior circuit is that a top voltage value exactly equal to the desired one cannot always be obtained, because it would be dependent on the sum of the discrete Zener values, and optimum clamping cannot be achieved.

Furthermore, since the voltage drops across the Zener diodes and at the control terminal of the power transistor depend on temperature in different degrees, compensation can only be obtained for certain definite values of VD.

In an attempt to obviate such drawbacks, the second prior art solution provides a combination of diodes, Zener diodes, and transistors in the recycle circuit.

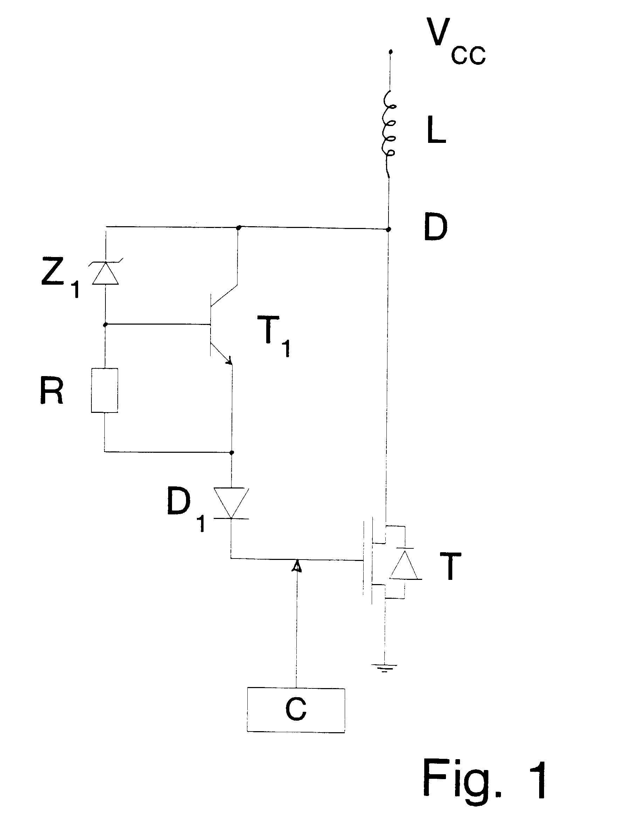

One of the last-mentioned circuit arrangements is depicted in figure 1. One of the last-mentioned circuit arrangements is depicted in Figure 1.

The circuit in Figure 1 operates as follows.

Upon the driver circuit C for the power element turning off the transistor T, an overvoltage is generated at node D. As this voltage reaches a value V_{D}=V_{Z}+V_{BE}+V'_{BE}+V_{GS} (where, V_{Z} is the Zener voltage of Z₁, V_{BE} is the voltage drop between the base and the emitter of transistor T₁, V'_{BE} is the voltage across diode D₁, and V_{GS} is the voltage drop between the gate and the source of transistor T when this is a field-effect transistor), the Zener diode begins to conduct, causing the transistor T to be turned back on.

Thus, current recycling from the inductive load is started.

It should be noted that Z₁, T₁ and D₁ in the Figure may represent a number N of Zener diodes, transistors and diodes connected in series, whereby V_{D} is the result of several potential drops combined.

In that way the discharge time of the inductive load can be optimized.

That circuit has, however, a disadvantage in that the voltage value at the node D is truly stable neither as temperature changes nor for each selected value of VD, although it is stabler through a broader temperature range than the previously mentioned conventional solution.

Another known solution for limiting at turn-off the drain voltage of a transistor driving an inductive element is disclosed for example in US Patent No. 4,860,152. The latter describes a snubber circuit, or transient inductive voltage protection circuit, which regulates the gate current of the MOSFET in relation to the drain voltage at turn-off, to clamp transient inductive voltages to a non-destructive level. This circuit is intended e.g. for application to driver circuits for automotive vehicle fuel injectors.

The snubber circuit includes means for sensing the magnitude of the transient inductive voltage, consisting of a resistive voltage divider, and a double stage regulating circuit which controls the turnoff of the MOSFET in response to the sensed voltage. The voltage divider is connected to the drain node of the MOS transistor. The double stage regulating circuit includes a current source and a current injection circuit, each of them functionally connected between the voltage divider and the gate of the MOSFET to be controlled by the sensed voltage and to supply a proper current to the gate of the transistor.

At the onset of the turn-off, the current source is activated by a proper signal to discharge the gate capacitance and the current injection circuit is maintained non conductive until the drain voltage is sensed below a predetermined limit value. As the gate capacitance is discharged and the drain voltage approaches its limit value, the magnitude of the current supplied by the current source is reduced thereby reducing the rate of discharge of the MOS and at the same time the current injection circuit is activated to supply additional current to the MOS gate and sustain the MOSFET conduction. When the inductive energy stored in the load is substantially dissipated the drain voltage falls; at such point the current injection circuit is disabled and on the other hand the conduction of the current source is increased to complete the turn-off of the MOSFET.

It can be appreciated that this known circuit allows to adequately protect the MOS transistor while reducing the number of external components, such as the diodes and Zener diodes included in the previous solutions, to only the resistors forming the voltage divider. However the complexity of the circuit is relatively increased. Furthermore the operation of the circuit is not temperature independent.

For completeness of discussion, it can also be worth describing a known solution for limiting the voltage rise occurring on an inductive load consisting of a transformer. This solution is disclosed for example in FR patent application 2593946. The latter is specifically applied to a transformer used for an electronically controlled automotive device for ignition.

It provides for a control circuit for limiting a voltage peak occurring at the primary winding of the transformer. The control circuit is connected to the primary winding and includes a current amplifier, substantially consisting of a transistor, and a comparator, both connected to the output of the primary winding. The same comparator, consisting of a current comparator with unitary gain having an input connected to said output of the primary winding through a resistor, and a constant current generator connected to a first output of the comparator represent means for transferring without attenuation the signal to be limited according to D2 invention. Furthermore a threshold circuit connects a second output of the comparator to the control terminal of the transistor.

When a voltage peak occurs at the primary winding of the transformer, the current entering the current comparator increases. Due to the fact that the first output is flown a constant current, the subsequent voltage increase at the second output of the comparator enables the threshold circuit to conduct. Therefore a current is directed to the control terminal of the current amplifier, which lower the voltage at the output of the transformer.

Because of the provision for means for transferring the signal without attenuation, the regulation is current based.

On the other hand it shows an optimum response specifically at high frequencies.

It is an object of this invention to provide a current-recycling circuit whose stability is unaffected by temperature.

A further object is to arrange for said temperature-wise stable feature to be retained as the maximum voltage value at any inductive load varies.

The invention and its advantages are more clearly illustrated by the accompanying drawings, in which:
- Figure 1 is a diagram of a prior art circuit for recycling current while an inductive load is being driven, whose operation has been discussed hereinabove; and
- Figure 2 is a diagram of a circuit for recycling current while an inductive load is being driven, according to this invention.

In either drawing figures, L denotes the inductive load, Vcc the voltage supply, and T the transistor through which the current recycling is performed.

This transistor is shown as a field-effect transistor, but may be a bipolar type, in accordance with the prior art.

In addition, the transistor T would normally be a power transistor.

Also shown is a driver circuit means as schematically indicated in block form at C.

D denotes the connection node between the inductive load, the current recycle control circuit, and the transistor T.

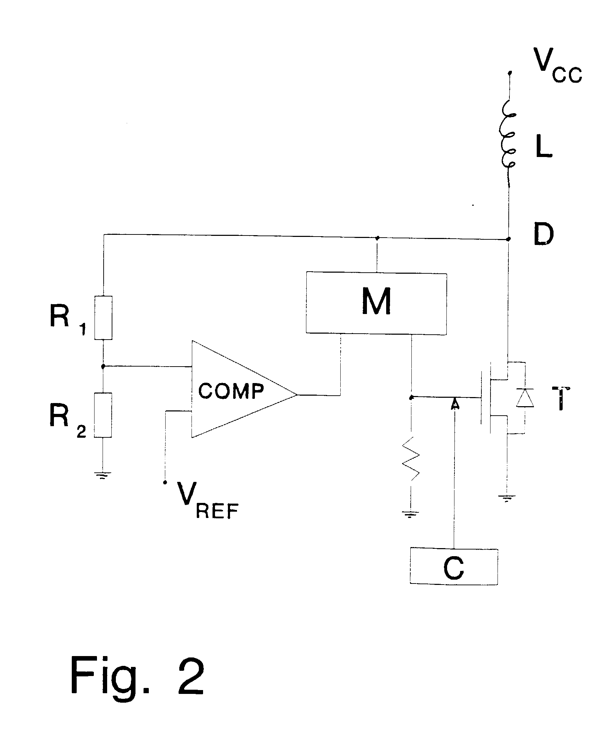

The circuit diagram in Figure 2 is one embodiment of this invention, further comprising a current mirror M, a comparator COMP, a voltage reference V_{REF}, and two resistors R₁ and R₂ forming a voltage divider.

The transistor T is connected in series with the inductive load L between ground and a terminal of a supply voltage source Vcc.

Connected to the control terminal T are a driver circuit means C and a control circuit which is also connected to the inductive load.

The control circuit is operative to determine the mode of turning the transistor T back on while allowing current to be recycled from the inductive load through T.

This control circuit comprises, in the example shown, the voltage divider R₁, R₂ connected between the inductive load and ground, the comparator COMP, and the current mirror M.

The comparator COMP has two input terminals connected to the divider and the voltage reference V_{REF}.

The current mirror M has an input leg connected to an output terminal of the comparator and an output leg connected to the control terminal of the transistor T, and feeds into the node D.

The circuit of this invention operates as follows.

In a similar manner to the conventional circuit shown in Figure 1, the transistor T is turned on again for current recycling depending to the voltage value at the node D.

Upon that voltage attaining a predetermined value V_{D}=V_{REF}(R₁+R₂)/R₂ , which also represents the comparator threshold, the comparator will output a signal causing the transistor to be turned on again.

Thus, current recycling is triggered from the inductive load L to clamp the voltage at node D to the value V_{D}.

The transistor T is held in the "on" state until all of the inductive load energy is discharged. The choice of V_{D} is obtained at once by suitably proportioning the divider ratio (R₁+R₂)/R₂. (Of course, each of the resistors R₁ and R₂ shown in Figure 2 may represent a number N of resistors).

This recycle circuit is highly stable temperature-wise because the temperature variation of V_{D} is only dependent on the voltage reference VREF, which can be selected to be temperature stable.

This reference can be expediently provided using, for example, a Widlar device known as bandgap.

It should be noted that V_{REF} may be either positive or negative.

The current mirror allows a current to be supplied which may be amplified, if desired.

However, it is not essential to the invention, and other circuit elements may be used to have the transistor turned on.

It should be considered that where the voltage at node D attains a high value in operation, the resistor R₁ and current mirror, being connected to that node, are required to operate at a high voltage.

The current-recycling circuit just described has the advantage of being substantially stable temperature-wise by virtue of the voltage control being implemented by a divider and a voltage reference being used.

Furthermore, any value may be selected for the voltage V_{D} by appropriate variation of the resistive divider. The current-recycling transistor T shown by way of example may be replaced with another active element, such as a Darlington, effective to drive the inductive load and recycle its discharge current.

The voltage divider may be implemented in any desired way without impairing its effectiveness.

The current mirror, which in this example feeds into the node D for convenience, could alternatively be supplied another potential.

Instead of the low-side driver configuration shown in Figure 2, with the power transistor arranged to drive the load to the supply, the circuit could be a high-side driver configuration with the load being driven to ground by the power transistor.

## Claims

1. A circuit for recycling the discharge current of an inductive load (L) while it is being driven, comprising an active semiconductor device (T) having first and second terminals whereby it is connected in series with the inductive load (L) between first and second terminals of a voltage supply V_{CC} source and a control terminal for connection to a driver circuit means (C), and a control circuit means (L) (R₁,R₂,COMP) connected between the inductive load (L) and the control terminal of the active semiconductor device (T), and comprising a voltage divider (R₁,R₂) connected between the inductive load (L) and the first terminal of the supply voltage source, characterized in that said control circuit means further includes a voltage comparator (COMP) having first and second input terminals respectively connected to the voltage divider (R₁,R₂) and to a temperature stable voltage reference (V_{REF}), and an output terminal coupled to the control terminal of the semiconductor device (T).

2. A circuit according to Claim 1, characterized in that said control circuit means (C) further comprises a current mirror circuit (M) having an input leg connected to the output terminal of the voltage comparator (COMP) and an output leg connected to the control terminal of the active semiconductor device (T).

3. A circuit according to Claim 2, characterized in that the current mirror (M) has a supply terminal connected to the inductive load (L) .

4. A circuit according to any of the preceding claims, characterized in that the temperature stable voltage reference (V_{REF}) is provided by a Widlar device.

5. A circuit according to any of the preceding claims, characterized in that the active element (T) is a power transistor, and that the first and second terminals and the control terminal are a source terminal, drain terminal, and gate terminal, respectively.

## Patentansprüche

1. Schaltung zum Zurückführen des Entladestroms einer induktiven Last (L), während diese betrieben wird, umfassend ein aktives Halbleiterbauelement (T) mit einem ersten und einem zweiten Anschluß, über die es in Reihe bezüglich der induktiven Last (L) zwischen dem ersten und dem zweiten Anschluß einer Spannungsversorgungsquelle (Vcc) geschaltet ist, und einem Steueranschluß zur Verbindung mit einer Treiberschaltungseinrichtung (C) und eine Steuerschaltungseinrichtung (R₁, R₂, COMP), die zwischen die induktive Last (L) und den Steueranschluß des aktiven Halbleiterbauelements (T) gelegt ist und einen Spannungsteiler (R₁, R₂), der zwischen der induktiven Last (L) und dem ersten Anschluß der Versorgungsspannungsquelle liegt, aufweist,
**dadurch gekennzeichnet,**
daß die Steuerschaltungseinrichtung außerdem einen Spannungsvergleicher (COMP) aufweist, der einen ersten und einen zweiten Eingangsanschluß besitzt, die an den Spannungsteiler (R₁, R₂) bzw. an eine temperaturstabile Referenzspannung (V_{REF}) angeschlossen sind, und einen Ausgangsanschluß besitzt, der an den Steueranschluß des Halbleiterbauelements (T) gekoppelt ist.

2. Schaltung nach Anspruch 1,
**dadurch gekennzeichnet,**
daß die Steuerschaltungseinrichtung (C) außerdem eine Stromspiegelschaltung (M) enthält, die mit einem Eingangszweig an den Ausgangsanschluß des Spannungsvergleichers (COMP) und mit einem Ausgangszweig an den Steueranschluß des aktiven Halbleiterbauelements (T) angeschlossen ist.

3. Schaltung nach Anspruch 2,
**dadurch gekennzeichnet,**
daß der Stromspiegel (M) mit einem Versorgungsanschluß an die induktive Last (L) angeschlossen ist.

4. Schaltung nach einem der vorhergehenden Ansprüche,
**dadurch gekennzeichnet,**
daß die temperaturstabile Referenzspannung (V_{REF}) mit einem Widlar-Bauelement ausgestattet ist.

5. Schaltung nach einem der vorhergehenden Ansprüche,
**dadurch gekennzeichnet,**
daß das aktive Bauelement (T) ein Leistungstransistor ist, und daß der erste und der zweite Anschluß sowie der Steueranschluß der Source-, Drain- bzw. Gate-Anschluß sind.

## Revendications

1. Un circuit destiné à la recirculation du courant de décharge d'une charge inductive (L) alors qu'il est piloté, comprenant un dispositif semi-conducteur actif (T) ayant des première et seconde bornes par lesquelles il est connecté en série avec la charge inductive (L) entre des première et seconde bornes d'une source de tension d'alimentation (Vcc) et une borne de commande destinée à être connectée avec un circuit de pilotage (C), et un circuit de commande (R₁, R₂, COMP) connecté entre la charge inductive (L) et la borne de commande du dispositif semi-conducteur actif (T), et comprenant un diviseur de tension (R₁, R₂) connecté entre la charge inductive (L) et la première borne de la source de tension d'alimentation, caractérisé en ce que ledit circuit de commande comprend en outre un comparateur de tension (COMP) ayant des première et seconde bornes d'entrée respectivement connectées au diviseur de tension (R₁, R₂) et à une référence en tension stable par rapport à la température (V_{REF}), et une borne de sortie couplée à la borne de commande du dispositif semi-conducteur (T).

2. Un circuit selon la revendication 1, caractérisé en ce que ledit circuit de commande (C) comprend en outre un circuit en miroir de courant (M) ayant une branche d'entrée connectée à la borne de sortie du comparateur de tension (COMP) et une branche de sortie connectée à la borne de commande du dispositif semi-conducteur actif (T).

3. Un circuit selon la revendication 2, caractérisé en ce que le miroir de courant (M) a une borne d'alimentation connectée à la charge inductive (L).

4. Un circuit selon l'une quelconque des revendications précédentes, caractérisé en ce que la référence en tension stable par rapport à la température (V_{REF}) est fournie par un dispositif Widlar.

5. Un circuit selon l'une quelconque des revendications précédentes, caractérisé en ce que l'élément actif (T) est un transistor de puissance, et en ce que les première et seconde bornes et la borne de commande sont une borne de source, une borne de drain et une borne de grille, respectivement.
